(19) Europäisches Patentamt
European Patent Office
Office européen des brevets

(11) **EP 3 079 062 A1**

(12) **EUROPEAN PATENT APPLICATION**

(43) Date of publication:
**12.10.2016 Bulletin 2016/41**

(51) Int Cl.:
***G06F 11/00*** *(2006.01)*

(21) Application number: **16163888.7**

(22) Date of filing: **05.04.2016**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **09.04.2015 DE 102015105396**

(71) Applicant: **Zentrum Mikroelektronik Dresden AG 01109 Dresden (DE)**

(72) Inventor: **Kelly, Anthony Old Kildimo Co. Limerick (IE)**

(74) Representative: **Lippert, Stachow & Partner Patentanwälte Krenkelstrasse 3 01309 Dresden (DE)**

(54) **ELECTRONIC SYSTEM AND METHOD FOR ESTIMATING AND PREDICTING A FAILURE OF THAT ELECTRONIC SYSTEM**

(57) The present disclosure relates to an electronic system comprising elements and the elements comprising devices that limit the reliability of the electronic system and a method for estimating and predicting a failure of that electronic system. The task of the invention to realize a system that can monitor the parameters that affect electronic system, e.g. a power supply reliability such as temperature, and parameters that can predict power supply failure such as bulk capacitor ESR will be solved by a monitoring system measuring and monitoring at least one reliability limiting parameter of at least one of the devices connected to it. The electronic system with the monitoring system is used by a method comprising following steps: measuring parameters affecting or associating the reliability of the device by sensors, collecting the measured sensor data and/or other data by a communications unit, communicating the data to a computing device for processing and predicting a failure of the device and alerting to the failure.

## Fig. 2

**Description**

FIELD OF THE INVENTION

The present disclosure relates to an electronic system comprising elements and the elements comprising devices that limit the reliability of the electronic system.

The present disclosure also relates to a method for estimating and predicting a failure of that electronic system.

BACKGROUND OF THE INVENTION

Many electronic systems are expected to operate continuously and tolerate the failure of subsystems and devices. For example, the device failure rate in large scale computer systems means that some type of fault is expected every few hours but nevertheless, the system must remain operational. Several factors contribute to the reliability of the systems, including preventative maintenance and redundancy.

In power supplies the most common point of failure is the bulk capacitors, which have lifetimes of the order of several thousands of hours, and have been the cause of many high profile end product recalls because of reliability issues. However, despite the problems caused by unreliable power supply capacitors, the costs associated with reliable design techniques remains a barrier to their adoption in anything other than high-end systems.

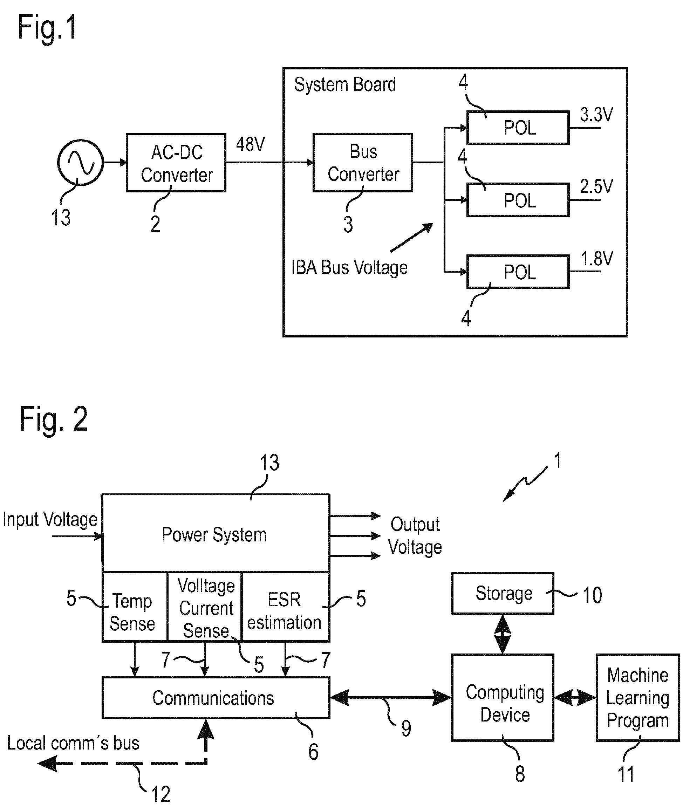

Power supplies typically include a power chain comprising of AC-DC conversion, power factor correction, bus conversion and point of load regulation, as illustrated in figure 1.

Typically, system designers ensure reliability by using techniques such as redundancy, derating, the use of more reliable components, thermal management etc. However the costs associated with these techniques mean that power supply reliability is expensive.

Redundancy involves duplicating aspects of the power system so that the additional units may take over the function of the failed device or unit. In addition to the higher cost of providing redundant units, this method also requires a failure to occur before the user is alerted.

Derating involves using components or devices at levels well below their rated specifications, which often involves more expensive and larger components or devices than would otherwise be necessary. As a component's or device's lifetime typically doubles per 10 degrees reduction in operating temperature, derating often involves expensive additional cooling.

Power supply telemetry data is often available by use of the popular PMBUS standard (power management bus standard). Although this has been adopted for monitoring and control, it has a limited role in power supply reliability and does not feature the necessary commands or protocol to communicate with a remote computer system.

In power supplies the most common point of failure are the bulk capacitors. Electrolytic capacitor reliability is significantly affected by the degradation of the liquid electrolyte, especially at elevated temperatures. Tantalum capacitors are an alternative, but they require voltage derating by up to 50% in order to prevent a potential fire hazard. Polymer capacitors are more expensive, but address many of the concerns associated with the reliability of electrolytic and tantalum types. However, a guaranteed lifetime of only 2000 hours is typical and significant degradation at high ripple currents may affect performance and reliability of the power supply.

Therefore what is required is a system that can monitor the parameters that affect power supply reliability such as temperature, and parameters that can predict power supply failure such as bulk capacitor ESR (equivalent series resistance).

BRIEF SUMMARY OF THE INVENTION

The disclosed invention describes an electronic system where at least one of the devices is connected to a monitoring system measuring and monitoring at least one reliability limiting parameter. An electronic system comprises elements and the elements comprise devices that limit the reliability pf the electronic system, therefore, the functionality of at least that device which limits the reliability of the electronic system most is monitored by a monitoring system.

In the disclosed invention the electronic system can be a power supply comprising elements like an AC-DC converter, a power factor correction, a bus converter and a point of load regulation and the device to be monitored is at least a device of one of these elements.

The monitoring system comprises functional units such as sensors for measuring device parameters, a communications unit communicating with the sensors, a computing unit connected to the communications unit, and a storage means associated with the computing unit. This system can monitor the parameters that affect power supply reliability such as temperature, and parameters that can predict power supply failure such as bulk capacitor ESR. Therefore, different sensors are used to measure relevant parameters. Those parameters are reported to a communications unit that is connected with a computing unit whereas the computing unit may be integrated into a computer system. The communications unit may optionally pre-process the parameters to convert them to a more suitable form or may perform other suitable processing. The computing unit is running a machine learning program in order to predict the failure and lifetime of devices of the power supply. Such a system would have advantages in preventative maintenance by alerting the maintainer to an impending failure. The identification of a faulty product batch that is more prone to failure is another possible advantage. By running machine learning algorithms the system could update its failure probabilities and models based on the measured data and in turn, update the power supplies with the learned reliability data and parameters.

Optionally, the communications unit is connected to a local embedded host by a local communications bus, whereas the embedded host is located within a facility where the monitoring system is located. Therefore, the communicating status includes reliability and the status is communicated for example to microcontroller which may configure the power supply.

Furthermore, the computing unit and its associated storage means are located within a facility where the device to be measured is located meaning locally to the power supply, because the device is part of an element of the electronic system, namely the power supply. Or in another embodiment the computing unit and its associated storage means are located outside a facility where the device to be measured is located namely in a different facility such as a remote data-center. It is therefore particularly advantageous to use the computing unit in a cloud computing based embodiment. It is also advantageous that the monitoring system is connected over cloud computing means with other power supplies and the sensors of these other power supplies building up a database of parameters. Such a cloud based embodiment would allow the Machine Learning system to communicate with many power supplies with the benefit of learning from multiple sensors and power supplies. Additionally, such an embodiment has redundancy benefits against data-center failure or data loss.

The computing unit is an ASIC or a FPGA in order to adapt the performance of the monitoring system individually to the present circumstances. Signals are output from the ASIC or FPGA to alert the user to an impending failure or provide an indication of time to failure or the like.

The computing unit may be configured to communicate the imminent failure to the power supply to alert the user. The optional local microcontroller may perform the Alert function. In order to signalize that the computing unit has calculated or would predict an impending failure and a limited lifetime of the power supply, the computing unit is connected to indicator function means such as a light emitting diode or a status register.

Advantageously, the monitoring system is incorporated into a digital power control IC or a power management integrated circuit (PMIC) comprising all of the power controllers, sensors, estimators, observers and communications and processing logic. The result is a very compact construction and design type.

Where IC technology allows, the monitoring system may be integrated on a chip. A System on Chip (SoC) may be feasible in which the sensor, processing and learning algorithms are incorporated into an integrated circuit. Suitably, the power controller, drivers and switches of a switch mode power converter may be integrated.

The disclosed invention describes also a method for estimating and predicting a reliability limiting failure of an electronic system comprising following steps: measuring parameters affecting or associating the reliability of the device by sensors, collecting the measured sensor data and/or other data by a communications unit, communicating the data to a computing unit for processing and predicting a failure of the device and alerting to the failure. Appropriate sensors measure parameters known to affect, or may be associated with the reliability of the power supply. Such parameters may include output voltage, average current, temperature, ESR (equivalent series resistance) and capacitance of the bulk capacitors. System identification or estimation may be employed to infer unmeasured parameters or signals. These measured sensor data and/or other data is collected by a communications unit that can pre-process the parameters to convert them to a more suitable form or may perform other suitable processing or it communicates the data directly to the computing unit for processing and predicting a failure of the device and altering the failure.

Advantageously, the computing device runs a machine learning program for estimating, learning and predicting the failure of the device. The device can be a bulk capacitor of a power supply, but also a device of a power converter where reliability can be usefully monitored and predicted including elements such as AC-DC converters, Power Factor Correction, DC-DC converters, isolated and non-isolated converter types. In addition, the invention may also predict things other than failure and reliability. Similar techniques utilizing similar data may be used to predict when power saving modes should be switched on by monitoring power efficiency and computational demand on the system.

The machine learning program processes the collected and communicated sensor data and/or other data. Therefore, it uses algorithms such as Anomaly Detection, Neural Network, K-Nearest Neighbour, Linear Regression, Markov Chain Monte Carlo, Hidden Markov Modelling, Naive Bayes or Decision Trees. It will be clear to a person having ordinary skill in the art that other Machine learning algorithms may also be beneficial.

The computing unit may provide useful statistics and detailed performance data regarding the operation and reliability of the monitored power supplies to a user. In a cloud based embodiment this may be achieved via a suitably designed web interface. The advantage of using the monitoring system with the machine learning program is that the system could aggregate the data from many remote power supplies, building up a database of parameters and learning the failure probabilities according to the data. Such a system could utilize cloud computing features to collect sufficient data from many power supplies, over many vendors.

BRIEF DESCRIPTION OF THE DRAWINGS

Reference will be made to the accompanying drawings, wherein:

Fig. 1 shows a typical electronic power system (state of the art)

Fig. 2 shows an overview of the inventive system;

Fig. 3 shows a supervised classification algorithm;

Fig. 4 shows a classification example using the invention.

DETAILED DESCRIPTION OG THE INVENTION

In order to illustrate the advantages of the invention consider a power supply 13 whose parameters are measured by sensors 5 as shown in figure 2. Appropriate sensors 5 measure parameters known to affect, or may be associated with the reliability of the power supply 13. Such parameters may include output voltage, average current, temperature, ESR (equivalent series resistance) and capacitance of the bulk capacitors. System identification or estimation may be employed to infer unmeasured parameters or signals.

The communications unit 6 communicates 9 the parameters to the computing unit 8 and may optionally pre-process the parameters to convert them to a more suitable form or may perform other suitable processing. Optionally, a local communications bus 12 may be associated with the communications block 6, communicating status including reliability to a local embedded host such as a microcontroller which may also configure the power supply 13.

The computing unit 8 and its associated storage 10 and program code 11 may be located within a facility where the device to be measured is located, for example locally to the power supply 13 or outside a facility where the device to be measured is located namely in a different facility. For example in a cloud computing based embodiment the computing unit 8 would be suitably located in a remote data-center. Such a cloud based embodiment would allow the monitoring and machine learning system to communicate with many power supplies with the benefit of learning from multiple sensors and power supplies. Additionally, such an embodiment has redundancy benefits against data-center failure or data loss.

The computing unit 8 may run a machine learning program 11, the purpose of which is to estimate and predict the failure of the power supply 13 by processing the communicated sensor data 7 and/or other data that may be available such as user inputted data. The computing unit 8 may be configured to communicate the imminent failure to the power supply 13 to alert the user. The optional local microcontroller may perform the Alert function.

The computing unit 8 may provide useful statistics and detailed performance data regarding the operation and reliability of the monitored power supplies 13 to a user. In a cloud based embodiment this may be achieved via a suitably designed web interface.

In another embodiment the machine learning algorithm 11 may execute on an ASIC or an FPGA whereby signals are output from the ASIC or FPGA to alert the user to an impending failure or provide an indication of time to failure or the like.

The monitoring and machine learning system 1 may execute algorithms 11 such as Anomaly Detection, Neural Network or K-Nearest Neighbour to predict the probability of power supply failure based upon the data received. It will be clear to a person having ordinary skill in the art that other Machine learning algorithms such as Linear Regression, Markov Chain Monte Carlo, Hidden Markov Modelling, Naive Bayes, Decision Trees and the like, may also be beneficial.

Considering an embodiment in which a Bayesian Inference algorithm receives data from the power supply (or supplies). Given the data D and various models M1, M2 incorporating parameters and representing various scenarios such as 1) a power supply close to failure and 2) a power supply 13 far from failure, the impending failure of the power supply 13 can be determined by executing an algorithm 11 according to Baye's rule in order to select the most appropriate model for the data (close to failure or far away from failure):

$$p(M_i | D) = \frac{p(D | M_i) \cdot p(M_i)}{p(D)}$$

where i selects the model, $p(M_i|D)$ is the posterior indicating the probability that the data applies to Model i, $p(D|M_i)$ is the likelihood of the data given the model and is the prior probability. This algorithm may be continuously updated to learn from new data with the prior being seeded by the posterior on each iteration. Competing models may be evaluated according to the ratio of their posteriors to determine which scenario is more likely. It will be clear that several additional parameters and models are easily accommodated by the algorithm by means of the calculation of joint probabilities in order to establish the probability of failure.

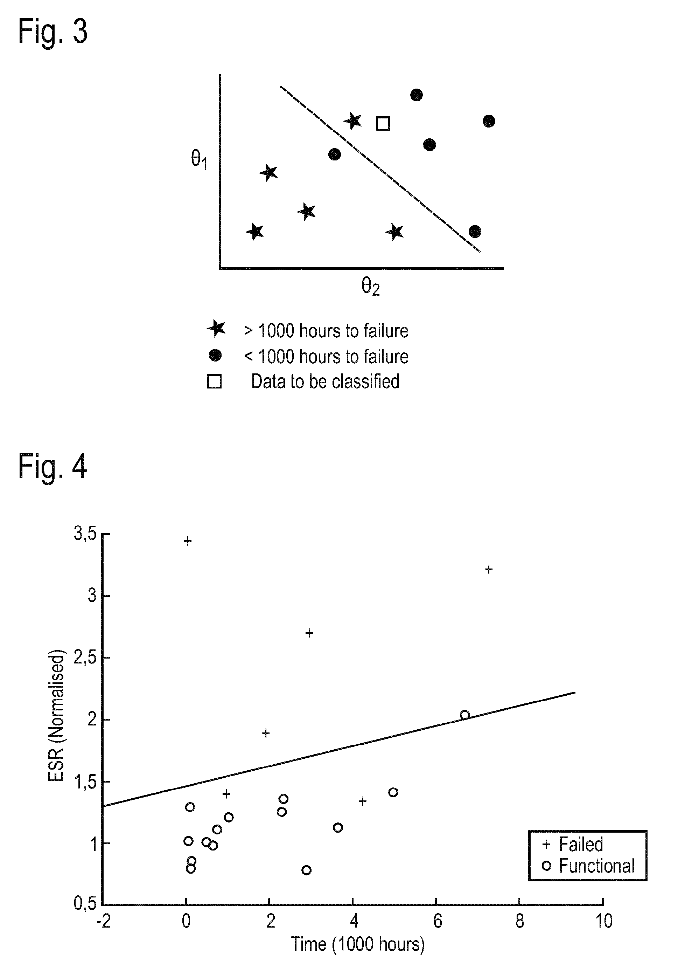

Considering an embodiment in which a supervised classification type of algorithm such as K-Nearest Neighbour (KNN) is employed. Figure 3 depicts the parameter space (simplified to two parameters for clarity), consisting of parameters such as temperature, ESR, hours of operation and the like, denoted as θ1 and θ2. Training data is denoted by stars for devices that are known to be greater than 1000 hours from failure and circles for devices known to be less than 1000 hours from failure. During training, the requirement of the machine learning algorithm such as KNN is to optimally divide the parameter space, into regions according to the most likely classification in the presence of noise and uncertainty in observations and underlying variables, as denoted by the dashed line. Once trained, the KNN algorithm is required to classify data of unknown classification that is presented to it, as denoted by the square symbol. The KNN can learn continuously as the correct classification of the data becomes known by observation over time.

Having learned the reliability of the power supply 13, the monitoring system 1 may take action based upon that learning. For example, an indicator function such as an LED or a status register may alert a user or supervising system to take suitable action. In a data center a supervising unit could move processing tasks away from a server that is predicted to suffer an imminent failure. In another example, an organization may be alerted to a batch of product with abnormally early failures and may issue a product recall. In another example, having been alerted to imminent failures, a supplier may re-configure the affected product to avoid the imminent failure or to minimize the damage caused.

It may be advantageous to incorporate the teachings of this invention into a digital power control IC or a Power Management Integrated Circuit (PMIC) whereby integration of some or all of the power controllers, sensors, estimators, observers and communications and processing logic is economical. Such a device would usefully incorporate a local communications bus for the purposes of configuration and monitoring of the power controller including reliability status. Where integration with a power controller may not be economical or compatible an IC or Sub-System according to the teachings of this invention can be envisaged.

Where IC technology allows, a System on Chip (SoC) may be feasible in which the sensor, processing and learning algorithms are incorporated into an integrated circuit. Suitably, the power controller, drivers and switches of a switch mode power converter may be integrated.

It can be envisaged that the teachings of this invention are not limited and are suitable for all power converters where reliability can be usefully monitored and predicted including AC-DC converters, Power Factor Correction, DC-DC converters, isolated and non-isolated converter types.

End equipment such as servers, data centers, network switches and infrastructure may all benefit from the teachings of this invention.

This invention also suggests a method of learning and estimating device and system reliability according to the disclosed teachings.

In addition, the invention may predict things other than failure and reliability. Similar techniques utilizing similar data may be used to predict when power saving modes should be switched on by monitoring power efficiency and computational demand on the system.

## Reference signs

1    Monitoring system
2    AC-DC converter
3    Bus converter
4    Point of load regulation
5    Sensors
6    Communications unit
7    Connection between sensors and communications unit
8    Computing unit
9    Connection between communications unit and computing unit
10   Storage means
11   Machine learning program
12   Communications bus
13   Power supply

## Claims

1. Electronic system comprising elements and the elements comprising devices that limit the reliability of the electronic system, **characterized in that** at least one of the devices is connected to a monitoring system (1) measuring and monitoring at least one reliability limiting parameter.

2. Electronic system according to claim 1, **characterized in that** the electronic system is a power supply (13) comprising elements as an AC-DC converter (2), a power factor correction, a bus converter (3) and a point of load regulation (4) and the device to be monitored is at least a device of one of these elements.

3. Electronic system according to claim 1 or 2, **characterized in that** the monitoring system (1) comprises sensors (5) for measuring device parameters, a communications unit (6) communicating with the sensors (5), a computing unit (8) connected to the communications unit (6), and a storage means (10) associated with the computing unit (8).

4. Electronic system according to claim 1, **characterized in that** the communications unit (6) is connected to a local embedded host by a local communications bus (12) whereas the embedded host is located within a facility where the monitoring system is located.

5. Electronic system according to claim 1, **characterized in that** the computing unit (8) and its associated storage means (10) are located within a facility where the device to be measured is located.

6. Electronic system according to claim 1, **characterized in that** the computing unit (8) and its associated storage means (10) are located outside a facility where the device to be measured is located namely in a different facility such as a remote data-center.

7. Electronic system according to one of the previous claims, **characterized in that** the monitoring system (1) is connected over cloud computing means with other power supplies and the sensors of these other power supplies building up a database of parameters.

8. Electronic system (1) according to claim 3, **characterized in that** the computing unit (8) is an ASIC or a FPGA.

9. Electronic system according to claim 3, **characterized in that** the computing unit (8) is connected to indicator function means such as a light emitting diode or a status register.

10. Electronic system according to one of the previous claims, **characterized in that** the monitoring system (1) is incorporated into a digital power control IC or a power management integrated circuit (PMIC) comprising all of the power controllers, sensors, estimators, observers and communications and processing logic.

11. Method for estimating and predicting a reliability limiting failure of an electronic system comprising following steps: measuring parameters affecting or associating the reliability of a device by sensors (5), collecting the measured sensor data and/or other data by a communications unit (6), communicating (9) the data to a computing unit (8) for processing and predicting a failure of the device and alerting to the failure.

12. Method for estimating and predicting a reliability limiting failure of an electronic system according to claim 11, **characterized in that** the computing unit (8) runs a machine learning program (11) for estimating learning and predicting the failure of the device.

13. Method for estimating and predicting a reliability limiting failure of an electronic system according to claim 12, **characterized in that** the machine learning program (11) processes the collected and communicated sensor (5) data and/or other data.

14. Method for estimating and predicting a reliability limiting failure of an electronic system according to claim 11 to 13, **characterized in that** the machine learning program (11) uses algorithms such as Anomaly Detection, Neural Network, K-Nearest Neighbour, Linear Regression, Markov Chain Monte Carlo, Hidden Markov Modelling, Naive Bayes or Decision Trees.

15. Method for estimating and predicting a reliability limiting failure of an electronic system according to claim 11, **characterized in that** the computing unit (8) using in a cloud based environment is configured via a web interface.

# Fig.1

# Fig. 2

## Fig. 3

★  > 1000 hours to failure
●  < 1000 hours to failure
□  Data to be classified

## Fig. 4

Europäisches
Patentamt

European
Patent Office

Office européen
des brevets

# EUROPEAN SEARCH REPORT

Application Number

EP 16 16 3888

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2007/150236 A1 (WARIZAYA KANJI [JP]) 28 June 2007 (2007-06-28) * the whole document * | 1-15 | INV. G06F11/00 |
| X | WO 2009/155149 A1 (GEN ELECTRIC [US]; KASZTENNY BOGDAN Z [CA]; SOLLECITO LAWRENCE A [US];) 23 December 2009 (2009-12-23) * the whole document * | 1-15 | |
| X | US 2005/043925 A1 (HEPNER DAVID F [US] ET AL) 24 February 2005 (2005-02-24) * the whole document * | 1-15 | |

TECHNICAL FIELDS
SEARCHED (IPC)

G06F

The present search report has been drawn up for all claims

| Place of search | Date of completion of the search | Examiner |
|---|---|---|
| The Hague | 30 June 2016 | Kielhöfer, Patrick |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 3 079 062 A1**

## ANNEX TO THE EUROPEAN SEARCH REPORT
## ON EUROPEAN PATENT APPLICATION NO.

EP 16 16 3888

This annex lists the patent family members relating to the patent documents cited in  the above-mentioned European search report.
The members are as contained in the European Patent Office EDP file on
The European Patent Office is in no way liable for these particulars which are merely given for the purpose of information.

30-06-2016

| Patent document cited in search report | | Publication date | Patent family member(s) | | Publication date |
|---|---|---|---|---|---|
| US 2007150236 | A1 | 28-06-2007 | JP | 4349408 B2 | 21-10-2009 |
| | | | JP | 2007199052 A | 09-08-2007 |
| | | | US | 2007150236 A1 | 28-06-2007 |
| WO 2009155149 | A1 | 23-12-2009 | AU | 2009260382 A1 | 23-12-2009 |
| | | | BR | PI0909962 A2 | 06-10-2015 |
| | | | CA | 2726819 A1 | 23-12-2009 |
| | | | CN | 102067049 A | 18-05-2011 |
| | | | EP | 2300885 A1 | 30-03-2011 |
| | | | JP | 5548682 B2 | 16-07-2014 |
| | | | JP | 2011524591 A | 01-09-2011 |
| | | | KR | 20110020830 A | 03-03-2011 |
| | | | US | 2009312999 A1 | 17-12-2009 |
| | | | WO | 2009155149 A1 | 23-12-2009 |
| US 2005043925 | A1 | 24-02-2005 | NONE | | |

EPO FORM P0459

For more details about this annex : see Official Journal of the European Patent Office, No. 12/82